# EUROPÄISCHE PATENTSCHRIFT

(11) **EP 0 436 566 B1**
(45) Veröffentlichungstag und Bekanntmachung des Hinweises auf die Patenterteilung: **10.03.1993**
(21) Anmeldenummer: 89909381.9
(22) Anmeldetag: 23.08.1989
(51) Int. Cl.: H03H 9/145

(54) **WANDLER MIT WEGLASSWICHTUNG FÜR OBERFLÄCHENWELLENFILTER**
CONVERTER WITH OMISSION WEIGHTING FOR SURFACE WAVE FILTERS
TRANSDUCTEUR A PONDERATION PAR OMISSION POUR FILTRES A ONDES DE SURFACE

(30) Priorität: 29.09.1988 DE 3833101
(43) Veröffentlichungstag der Anmeldung: 17.07.1991
(73) Patentinhaber: SIEMENS AKTIENGESELLSCHAFT, 80333 München (DE)
(72) Erfinder: ANEMOGIANNIS, Kimon, D-8000 München 60 (DE); MÜLLER, Folkhard, D-8000 München 2 (DE)
(86) Internationale Anmeldenummer: DE8900554
(87) Internationale Veröffentlichungsnummer: WO9003691

(56) Entgegenhaltungen:
- WO-A-84/04433
- US-A- 4 468 642
- IEEE Transactions on Sonics and Ultrasonics, vol. SU-22, No 6 November1975 (New York, US) H.Engan:"Surface acoustic wave multielectrode transducers",pages 395-401, see figures 1-5; pages 395-397; "II. Transmission spectra of multielectrode transducers"

## Beschreibung

Die vorliegende Erfindung bezieht sich auf ein Oberflächenwellenfilter nach dem Oberbegriff des Patentanspruches 1, wie es aus der US-A- 4 468 642 bekannt ist. Dieses Filter hat Koppelwandler, die ungewichtet sind.

Oberflächenwellenfilter werden dazu verwendet, Signale eines vorgegebenen Frequenzbandes auszufiltern. Oberflächenwellenfilter mit einem Eingangswandler und mit einem Ausgangswandler haben an sich relativ schwaches Selektionsverhalten, bezogen auf die meisten praktischen Anwendungen, so daß zusätzliche Maßnahmen getroffen werden. Eine solche Maßnahme ist die Anwendung der Wichtungstechnik. Sie besteht darin, daß die in einem Interdigitalwandler zwischen den entgegengesetzt gepolten Wandlerfingern auftretende Wechselwirkung verteilt über den ganzen Wandler unterschiedlich gewählt wird. Diese Wichtung kann in unterschiedlicher Überlappungslänge jeweils zweier benachbarter, entgegengesetzt gepolter Wandlerfinger bestehen. Diese Überlappungswichtung weist an sich beste Frequenzselektion auf, sie besitzt aber auch störende Eigenschaften. Deshalb wendet man ggf. andere Wichtungstechniken an, zu denen die Weglaßwichtung gehört. Diese Art der Wichtung der Finger eines Wandlers besteht darin, daß von den jeweils paarweise entgegengesetzt gepolten Wandlerfingern einzelne Wandlerfinger weggelassen werden, so daß der Wandler Fingerlücken in Richtung der Wellenausbreitung im Wandler aufweist. Durch die bei Finger-Weglaßwichtung vorgebbar auftretende unterschiedliche Verteilung der Anregungen im Wandler läßt sich eine damit vorgebbare Selektion erreichen. Leider hat aber die Finger-Weglaßwichtung wiederum ihre Nachteile, nämlich daß Volumenwellenanregung bzw. Konversion auftritt, Wellenführungsprobleme bei Anwendung von oberflächennahen Volumenwellen (anstatt Rayleighwellen im engeren Sinne von Oberflächenwellen) in Erscheinung treten und der Entwurf eines solchen Filters dadurch erschwert ist, daß unterschiedlich starke Anregungen, verursacht durch die Ladungsverteilungen, zu berücksichtigen sind.

In der Druckschrift WO 84/04433 ist eine spezielle Ausführung einer Finger-Weglaßwichtung beschrieben, bei der die an sich wegzulassenden Finger nicht weggelassen, sondern mit der mit Masse angeschlossenen Sammelschiene verbunden sind.

Eine noch andere Art einer Wichtung beschreibt BRISTOL, T.W.: "Synthesis of Periodic Unapodized Surface Wave Transducers. In: IEEE Ultrasonics Symposium Proceedings. 1972, S. 377 bis 380, nämlich eine Fingerwichtung durch Phasensprünge d.h. mit gegenphasigen Fingergruppen in der Fingerfolge.

Aufgabe der vorliegenden Erfindung ist ein auf der Grundstruktur des US-A- 4 468 642 beruhendes Koppelfilter hinsichtlich seiner Bändbreite, auf den jeweiligen Einzelfall zugeschnitten, verändern zu können, und zwar ohne daß es notwendig wird, jeweils einen neuen Entwurf erstellen zu müssen.

Diese Aufgabe wird mit den Maßnahmen des Patentanspruches 1 gelöst.

Figur 1 zeigt einen bekannten ungewichteten Wandler.

Figur 2 zeigt einen einzelnen, an sich bekanntermaßen gewichteten Wandler, wie er paarweise für die Koppelwandler 43, 53 eines erfindungsgemäßen Filters verwendet ist und

Figur 3 ein solches Filter mit den gewichteten Koppelwandlern.

Die vorliegende Erfindung beruht auf dem Gedanken, eine Verbesserung des Standes der Technik durch Verwendung wie oben in der WO 84/04433 beschrieben gewichteter Wandler in einem Filter nach Art des Filters der obengenannten US-A- 4 468 642 zu erreichen. Mit einem solchen erfindungsgemäßen Koppelfilter ist erhöhte Selektion zu erreichen, ohne daß die Filterverluste größer werden, was für Low-Loss-Filter ein ganz wesentlicher Effekt ist für die Einhaltung vorgegebener Anpaßbedingungen, nämlich, daß anders als beim bekannten Koppelfilter, die Gesamt-Fingeranzahl nicht bereits festgelegt ist. Man kann bei der Erfindung ohne zusätzliche Verluste die Gesamtanzahl der Finger der einzelnen Koppelwandler (natürlich in Grenzen) verändern, nämlich um außerdem noch die Bandbreite des Filters wahlfrei einstellen zu können.

Weiter wird nachfolgend die bei der Erfindung verwendete Fingerwichtung näher beschrieben. Statt in der synchronen Folge der aktiven Finger einzelne Wandlerfinger tatsächlich wegzulassen, solche an sich wegzulassende Wandlerfinger lediglich inaktiv zu machen. Dies wird dadurch erreicht, daß bei einem Wandler 100 der Figur 2 in der Folge der ansonsten der mit einen Sammelschiene (busbar) (a) der beiden Sammelschienen (a, b) elektrisch verbundenen also aktiven Wandlerfingern die aus dieser synchronen Folge an sich wegzulassenden Wandlerfinger als dann inaktive Finger stattdessen mit der entgegengesetzt gepolten anderen Sammelschiene (b) elektrisch verbunden werden. Es folgen dann dort auf einen mit dieser anderen Sammelschiene (b) verbundenen aktiven Wandlerfinger unmittelbar mehrere (drei, fünf, sieben ....) Wandlerfinger, die ebenfalls mit dieser anderen Sammelschiene (b) elektrisch verbunden sind. Von diesen ist aber der erste, dritte, fünfte dieser Finger ein jeweils inaktiver Finger. Für den Wandler hat dies den Vorteil, daß in Richtung der Wellenausbreitung fortlaufend ( aktive und soweit vorgesehen dazwischen inaktive) Wandlerfinger aufeinanderfolgen und die Kontinuität der Wandlerstruktur gewahrt ist. Elektrisch ergeben sich Anregungen nur zwischen entgegengesetzt gepolten benachbarten Wandlerfingern, d.h. für Überlappungsgruppen bzw. aktive Fingergruppen. Zu einer solchen Fingergruppe gehören also jeweils drei benachbarte Wandlerfinger, von denen der mittlere Wandlerfinger mit der einen Sammelschiene und die beiden "äußeren" Wandlerfinger mit der anderen Sammelschiene verbunden sind. Zum Beispiel sind die Wandlerfinger 11, 12 und 13 einerseits und die Wandlerfinger 12, 13, 14 andererseits je eine solche aktive Fingergruppe, d.h. insgesamt synchrone Fingergruppe. Weitere aktive Fingergruppen sind die Wandlerfinger 13, 14, 15 bzw. die Wandlerfinger 14, 15, 16 usw.. Eine inaktive Wandlergruppe bilden dagegen die Wandlerfinger 13, 17 und 18. Wie aus Fig. 2 ersichtlich, muß bei der Erfindung jeder zweite Finger 13, 18, 118, 218 .. mit ein und derselben (b) der zwei Sammelschienen verbunden sein (Synchronität ohne Phasensprung).

Diese als diskrete Weglaßwichtung bezeichnete Fingerwichtung mit lediglich elektrisch "weggelassenen" Wandlerfingern 17 hat den Vorzug, daß jede aktive Fingergruppe in gleich starker Weise eine akustische Welle anregt, nämlich gleichgültig, ob die nächstfolgende (und/oder vorangehende) Fingergruppe eine aktive Fingergruppe (11, 12, 13) oder eine inaktive Fingergruppe (13, 17, 18) ist.

Von besonderem Vorteil ist die hier beschriebene Wichtung für unsymmetrisch zu betreibende Wandler, bei denen diejenige Sammelschiene (b), mit der diese an sich wegzulassenden Wandlerfinger 18 zusätzlich verbunden sind, auf Masse gelegt, z.B. mit dem Gehäuse verbunden ist. Der Wandler hat damit minimale Anzahl "heißer" Finger, womit das Übersprechen minimiert ist.

Bei einem symmetrisch zu betreibenden Wandler der beschriebenen Art kann diese Fingerwichtung sinnvoll auch so ausgeführt werden, daß "wegzulassende" Finger wahlweise gemischt mit der jeweils anderen Sammelschiene verbunden sind.

Diese Art der Wichtung kann durch eine binäre Folge beschrieben werden, und zwar ist dazu die Anschlußfolge von Wandlerfingern bezogen auf diejenige Sammelschiene (a) relevant, bei der der elektrische Anschluß einzelner Wandlerfinger 17, nämlich entsprechend der Wichtung, fehlt. Eine aktive Fingergruppe 11, 12, 13 wird z.B. mit einer "1" und eine inaktive Fingergruppe 13, 17, 18 wird mit einer "0" bewertet. Die "0" und "1"-Folge gibt durch ihre Fourier-Transformierte die Charakteristik des betreffenden Wandlers an. Damit vereinfacht sich der Entwurf für den Wandler bzw. das Filter und die Optimierung der Wichtungsfolge. Die beschriebene diskrete Weglaßwichtung erzeugt ein rechteckiges akustisches Wellenprofil. Beugungseffekte treten nicht auf, da keine verkürzten Überlappungen auftreten. Die hier periodisch auftretende Oberflächen-"Störung" bietet sich für die Wellenführung von oberflächennahen Volumenwellen wie SSBW-Wellen und dgl. an.

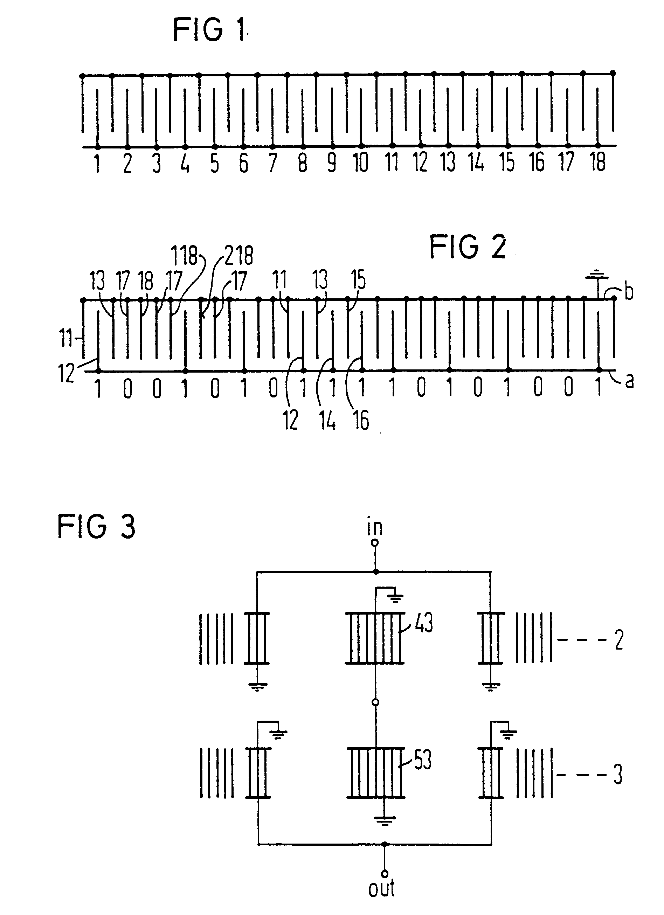

Erfindungsgemäß erfolgt die Anwendung der voranstehend beschriebenen Wichtung bei den Koppelwandlern in einem Oberflächenwellenfilter des Prinzips eines Filters der US-A- 4 468 642. Diese Druckschrift zeigt insbesondere in ihrer Figur 3 ein solches Filter, das aus sechs Wandlern und vier zusätzlichen Reflektoren (für unidirektionale Wirkung) besteht. Bei einem aus der genannten US-Patentschrift bekannten Filter (das hier interessierende Kernstück desselben ist in der beigefügten Figur 3 wiedergegeben) sind die Koppelwandler 43, 53 wichtig. Sie bestimmen weitestgehend die Filtercharakteristik des betreffenden Filters. Sie koppeln die Spur 2 der Eingangsseite und die Spur 3 der Ausgangsseite des Filters miteinander. Besonders wichtig ist die Anpassung der elektrischen Impedanz der Wandler 43 und 53 untereinander, nämlich die elektrische Anpassung im Durchlaßbereich des Filters. Die Wandlerimpedanz ist aber von der Anregung der akustischen Welle abhängig, wobei diese Anregung wiederum durch die Ladungsverteilung auf den Wandlerfingern und durch den Kopplungskoeffizienten des Substratmaterials, auf dem die angesprochenen Wandle: angeordnet sind, beeinflußt ist.

Über den Durchlaßbereich des Filters hinweg muß diese angesprochene Impedanz der Koppelwandler und somit die in ihnen auftretende elektroakustische bzw. akustoelektrische Anregung konstant sein.

Vorteilhafterweise gilt für die verwendete diskrete Wichtung, daß, wie schon oben angesprochen, die Anregung proportional der Anzahl der im Wandler vorhandenen aktiven Fingergruppe ist. Für eine vorgegebene Wandlerimpedanz ist für einen mit dieser Wichtung ausgestatteten Wandler die erforderliche Anregung, d.h. die notwendige Anzahl von aktiven Fingergruppen festgelegt. Sind diese aktiven Fingergruppen mit "1" bewertet, so ergibt die Summe der "1" einen der Wandlerimpedanz entsprechen den Wert. Es genügt dann, bei weiterer Optimierung des Wandlers bzw. des Filters diese Summe der "1" konstant zu halten.

Ein besonderer Anwendungsfall für die Erfindung ist, auch das Low-Loss-Filter nach der zeitgleichen Patentanmeldung PCT/DE 89/00553 (WO90/03690) der Anmelderin der voliegenden Erfindung, das erfindungsgemäß ausgebildete Koppelwandler hat, in seiner Bandbreite vorgeben zu bemessen ist, ohne daß die für dieses Filter wichtige Impedanz in ihrer Größe beeinflußt wird. Die Bandbreite hängt in einem solchen Filter (z.B.) von der in Wellenfortpflanzungsrichtung gemessenen Länge (= Anzahl der Fingerperioden) der Koppelwandler 43, 53 ab. Ein einmal erstellter Entwurf, der auch vorgegebene Impedanz, d.h. eine festgelegte Anzahl der aktiven Fingergruppen bzw. "1" hat, kann hinsichtlich seiner Bandbreite in der Weise problemlos angepaßt bzw. variiert werden, indem zusätzliche inaktive Fingergruppen, d.h. nach obiger Bewertung binäre Nullen "0" eingefügt werden. Es ist lediglich die vorgegebene symmetrische oder antisymmetrische Verteilung der binären "1"-Werte als Randbedingung beizubehalten.

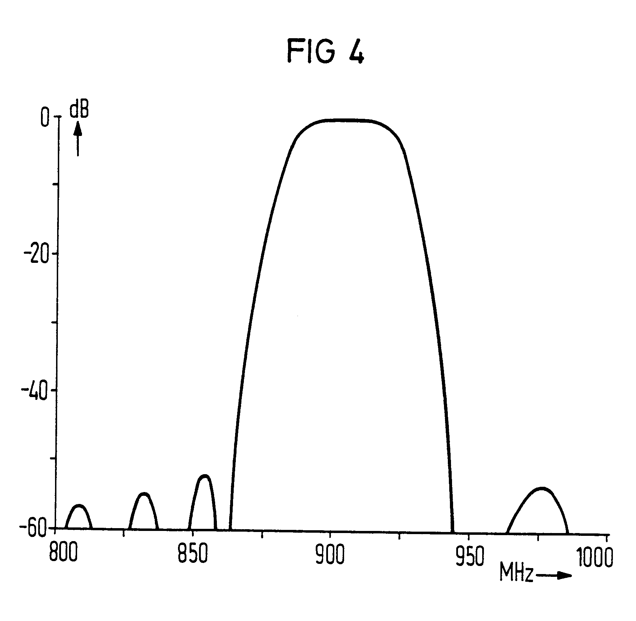

Figur 4 zeigt eine Durchlaßkurve eines Filters mit erfindungsgemäß verwendeter "diskreter" Weglaßwichtung der Koppelwandler. Durch z.B. Hinzufügung weiterer inaktiver Fingergruppen bei beibehaltener Symmetrieart (symmetrisch oder antisymmetrisch) läßt sich die Bandbreite des Filters, d.h. die Breite des Hauptmaximums (Durchlaßbereich) entsprechend vergrößern. Die Impedanz des Wandlers bleibt bei dieser Änderung unverändert.

## Patentansprüche

1. Low-Loss-Filter
mit miteinander elektrisch angepaßt gekoppelten Koppelwandler (43, 53) in zwei Spuren (2, 3) des Filters, wobei außerdem die eine Spur (2) die Wandler des Eingangs (in) und die andere Spur (3) die Wandler des Ausgangs (out) enthält,
**gekennzeichnet dadurch,**
daß für wahlfrei vorgebbare Bandbreite bei durch den Filterentwurf festgelegter Impedanz
eine solche Finger-Weglaßwichtung der Koppelwandler (43, 53) vorgesehen ist, bei der in der Folge der vorhandenen Wandlerfinger (12, 14, 16) der jeweils einen vorgegebenen Sammelschiene (a) der Koppelwandler (43, 53), deren Anzahl die vorgegebene Impedanz bestimmt, entsprechend weggelassene Wandlerfinger (17) zusätzlich in die synchrone Folge (13, 18, 118, 218) der aktiven Wandlerfinger der jeweils anderen Sammelschiene (b) der Koppelwandler (43, 53) als in dieser Folge dann inaktive Wandlerfinger (17) eingefügt und mit dieser anderen Sammelschiene (b) elektrisch verbunden sind, und
daß diese so gewichteten Koppelwandler (43, 53) symmetrisch aufgebaute Wandler sind.

2. Filter nach Anspruch 1,
**gekennzeichnet dadurch,**
daß die andere Sammelschiene (b), mit der diese an sich wegzulassenden Wandlerfinger (17) verbunden sind, auf Masse gelegt ist.

3. Filter nach Anspruch 1,
**gekennzeichnet dadurch,**
daß für symmetrischen Betrieb die an sich wegzulassenden Wandlerfinger (17) gemischt wahlweise mit der jeweils entgegengesetzt gepolten, anderen Sammelschiene (b) verbunden sind.

## Claims

1. Low-loss filter having coupling transducers (43, 53) coupled electrically matched to one another in two tracks (2, 3) of the filter, it being the case, moreover, that the one track (2) contains the transducers of the input (in) and the other track (3) the transducers of the output (out), characterised in that, by an optionally prescribable bandwidth in conjunction with an impedance fixed by the filter design, finger omission weighting of the coupling transducers (43, 53) is provided such that transducer fingers (17) correspondingly omitted in the sequence of the existing transducer fingers (12, 14, 16) of the respective one prescribed bus bar (a) of the coupling transducers (43, 53), the number of which determines the prescribed impedance, are additionally inserted into the synchronous sequence (13, 18, 118, 218) of the active transducer fingers of the respective other bus bar (b) of the coupling transducers (43, 53) as transducer fingers (17) when inactive in this sequence and are electrically connected to this other bus bar (b), and in that these coupling transducers (43, 53) weighted in this fashion are symmetrically constructed transducers.

2. Filter according to Claim 1, characterised in that the other bus bar (b), to which these transducer fingers (17) to be inherently omitted are connected, is connected to earth.

3. Filter according to Claim 1, characterised in that, for symmetrical operation, the transducer fingers (17) to be inherently omitted are optionally connected mixed to the respectively oppositely polarised, other bus bar (b).

## Revendications

1. Filtre à faibles pertes, à transducteurs de couplage (43, 53) adaptés électriquement et couplés entre eux dans deux pistes (2, 3) du filtre, la première piste (2) comportant le transducteur d'entrée (in) et l'autre piste (3) le transducteur de sortie (out),
caractérisé en ce que,
pour une bande passante pouvant être prescrite de manière optionnelle, et pour une impédance déterminée pour la conception du filtre, il est prévu une pondération par omission de doigts du transducteur (43, 53), pour laquelle, dans la succession des doigts (12, 14, 16) qui sont présents dans le transducteur d'une barre collectrice (a) prescrite des transducteurs de couplage (43, 53) et dont le nombre détermine l'impédance prescrite, sont inséres des doigts (17) de transducteur, qui sont à omettre de manière adéquate, dans la succession synchrone (13, 18, 118, 128) des doigts actifs de l'autre barre collectrice (b) des transducteurs actifs de couplage (43, 53), en tant que doigts (17) du transducteur alors inactifs dans ladite succession, et sont reliés électriquement à cette autre barre collectrice (b), et
en ce que ces transducteurs de couplage (43, 53) pondérés sont des transducteurs symétriques.

2. Filtre selon la revendication 1,
caractérisé en ce que,
ladite autre barre collectrice (b), à laquelle sont reliés ces doigts (17) de transducteur qui sont à omettre, est reliée à la masse.

3. Filtre selon la revendication 1,
caractérisé en ce que,
pour un fonctionnement symétrique, les doigts (17) du transducteur, qui sont à omettre, sont, en étant mélangés au choix, reliés à ladite autre barre collectrice (b) qui est de polarité inverse.
